Europäisches Patentamt

European Patent Office

Office européen des brevets

(19)

(11) Publication number: **0 472 902 A2**

# EUROPEAN PATENT APPLICATION

(21) Application number: **91112363.6**

(22) Date of filing: **24.07.91**

(51) Int. Cl.5: **G01R 31/26**, G01R 27/02, H03K 17/18

(30) Priority: **28.08.90 US 573969**

(43) Date of publication of application:
**04.03.92 Bulletin 92/10**

(84) Designated Contracting States:
**DE FR GB**

(71) Applicant: **INTERNATIONAL BUSINESS MACHINES CORPORATION**

**Armonk, NY 10504(US)**

(72) Inventor: **Woodworth, George K.**
**4800 Catharpin Road**
**Gainesvilli, VA 22065(US)**

(74) Representative: **Gaugel, Heinz, Dipl.-Ing.**
**IBM Deutschland GmbH Schönaicher Strasse 220**
**W-7030 Böblingen(DE)**

(54) Silicon controlled rectifier gate conduction detector.

(57) An apparatus and method relative to the operation of a silicon controlled rectifier for providing a determination when the SCR is completely off and capable of blocking an applied potential. The technique described senses the amplitude of the SCR voltage at the gate terminal (32) in reference to the cathode. After the driving signal (A) to the SCR is removed, the gate voltage in reference to the cathode, is monitored. A predetermined threshold voltage level is compared in a comparing means (IC2) to the measured gate to cathode voltage to provide a logical output level to indicate when the gate voltage places the SCR in a non-conductive off state.

FIG. 3

EP 0 472 902 A2

The invention disclosed broadly relates to power circuits and more particularly relates to SCR controlled power circuits.

In applications utilizing silicon controlled rectifiers (SCRs), it is frequently necessary to determine the time during which an SCR is actually conducting energy. After an SCR is gated on, it can internally regenerate its own gate drive signal from the "load's" energy source that the SCR is controlling. Until the load current is interrupted or is reduced to a level below a minimum sustaining level, the SCR will continue to be in a state of full conduction.

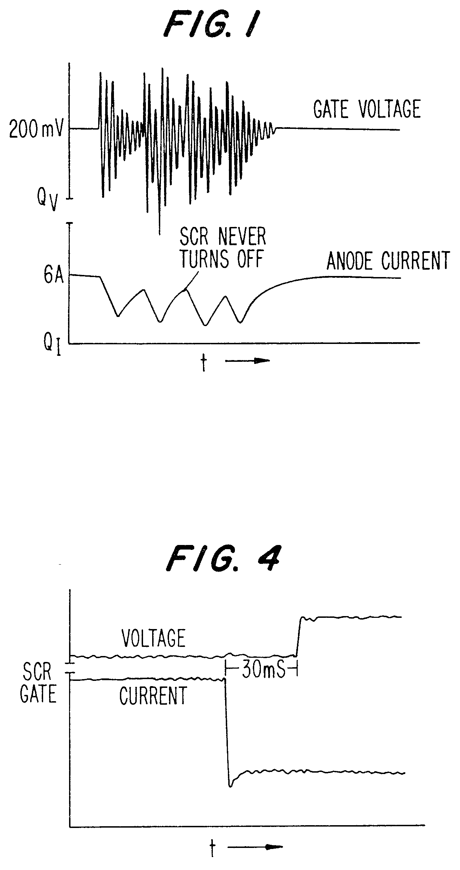

Fig. 1 indicates the interruption of a DC circuit controlled by an SCR after the external gate drive is removed. In this test, load interruptions were introduced that were too brief to allow the SCR to lose its internal gate charge, thus allowing the SCR to regenerate its gate drive and not switch off. The lower trace shows the anode current of six amps falling but never going to zero despite four successive load interruptions of several microseconds each. In order to turn off the SCR, it is necessary to remove the external gate drive signal, which interrupts the load current and allows the gate bias to decay to a low level.

Instrumentation may be used to monitor the source voltage or load voltage to determine the zero cross-over points which anticipate the SCR turn-off.

Electronic power supplies, reactive loads and distributed inductance in the power system can cause lagging phase currents that continue to flow after the source voltage passes through zero and begins to increase in the reverse polarity. This phase difference can lead to an error in measurement since the timing interval between the voltage zero cross-over point and the reversal of load current can be up to one fourth of a cycle or 90 electrical degrees. "Real world" load currents typically exhibit very abrupt waveforms that contain multiple harmonic frequencies. These disruptive currents are a function of the power source and load operating conditions. Zero anode to cathode current detection becomes very difficult as the higher frequency components become more visible in the low amplitude regions of the current waveform. This increased the noise level significantly, reducing the signal to noise ratio and contributes to greater measurement error in the determination of the SCR zero current turn-off point. It has been discovered that it is possible to "look" into the gate of an SCR and determine the point at which the device loses the ability to conduct current. This characteristic has been determined useful in circuits where timing considerations are important. This "noise free" gate signal is developed by the passage of anode to cathode load current, and results in a positive gate voltage signal measured with respect to the SCR's cathode.

With the present invention it is possible to "look" into the gate of an SCR and determine the point at which the device loses its ability to conduct current. This characteristic has been determined useful in circuits where timing considerations are important.

This "noise free" gate signal is developed by the passage of load current, and produces a positive gate voltage when measured with respect to the SCR's cathode. This is the potential that forward-biases the PN junction between the cathode and gate terminals. The gate voltage needed to trigger the SCR into conduction is only a few volts. After the SCR has been turned on, if sufficient loading is available, the SCR will continue to create its own gate drive voltage. External gate drive is only needed for a few microseconds during turn-on in a typical application, after which time it may be removed.

By sensing the voltage potential between the gate to cathode terminals, it is practical to determine the conduction status of the SCR. If the voltage source and load provide a sufficient current, the SCR will continue to conduct current and the gate potential with respect to the cathode will be about 1.5 volts, without any external drive.

If the external gate drive signal is removed and the load current falls below the minimum sustaining current for that SCR, the SCR gate potential will also fall to zero volts. There is a delay between the removal of the gate drive signal and the decay of the gate voltage to a low potential, which may require several microseconds. This delay will not cause an error in measurement of the SCRs turn off as it is the recombination time of the charges inside the SCR's junction. Reapplication of load voltage prior to this decay time could reinitiate SCR conduction due to this stored charge in the gate to cathode junction.

The present invention measures the amplitude of gate to cathode voltage of a SCR compares it to a reference voltage level. When the gate voltage is below the reference voltage, this is an indication that the SCR is completely turned off and capable of blocking an applied potential. The features and advantages of the invention will be more fully appreciated with reference to the accompanying figures.

Fig. 1
shows the interruption of a DC circuit controlled by an SCR after the external gate drive is removed.

Figs. 2A and 2B
illustrate the removal of a six amp anode current from an SCR.

Fig. 3
shows a circuit for achieving gate threshold detection of an SCR according to the present invention.

Fig. 4
shows the gate detector output.

Fig. 5
shows the residual SCR gate voltage at time of transition.

Fig. 6
shows the gate voltage signal applied during a turn-on pulse of an SCR and the resulting gate current waveform.

An SCR possesses the ability to regenerate its own gate signal and like all diode devices can store charge within its junctions. This storage of charges will cause the SCR to continue conduction after the load current falls to zero, unless the time period has allowed the charge to bleed off. In critical applications, it is a significant benefit to know the precise point at which an SCR is completely off and capable of blocking an applied potential.

The measurement technique described here senses the amplitude of the SCR voltage at the gate terminal. After the driving gate signal is removed, the amplitude of the gate voltage in reference to the cathode is monitored. In this approach, a threshold voltage level of 0.1 volts is chosen to determine when the SCR is completely turned off. A comparator monitors the gate potential and provides a logical output level to indicate when the gate voltage exceeds the DC threshold level of 0.1 volts.

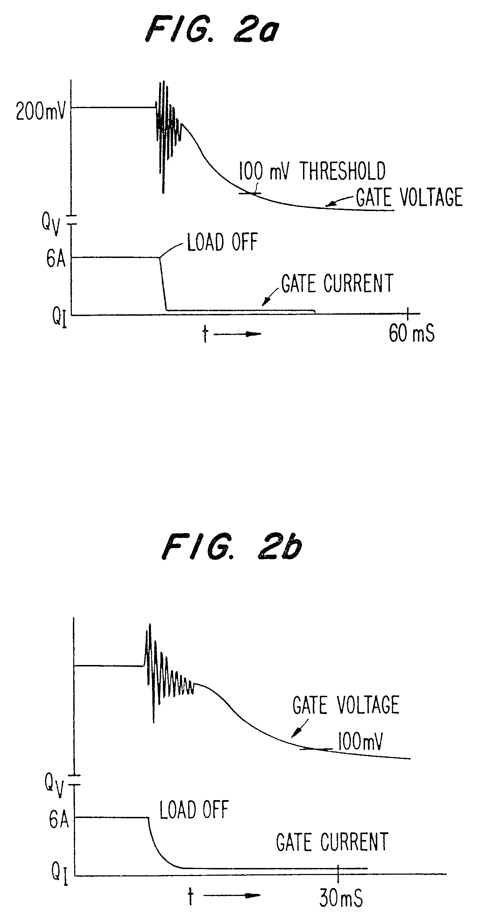

The lower trace shown in Figs. 2A and 2B illustrates the removal of a six amp anode current. The delayed voltage decay of the gate signal is shown in the upper trace. This illustrates that the charge inside this particular SCR required about 30 microseconds to fall below the 0.1 volt threshold. This time difference is not an error, for it represents the recombination time needed by the SCR's junction to restore its ability to block forward current.

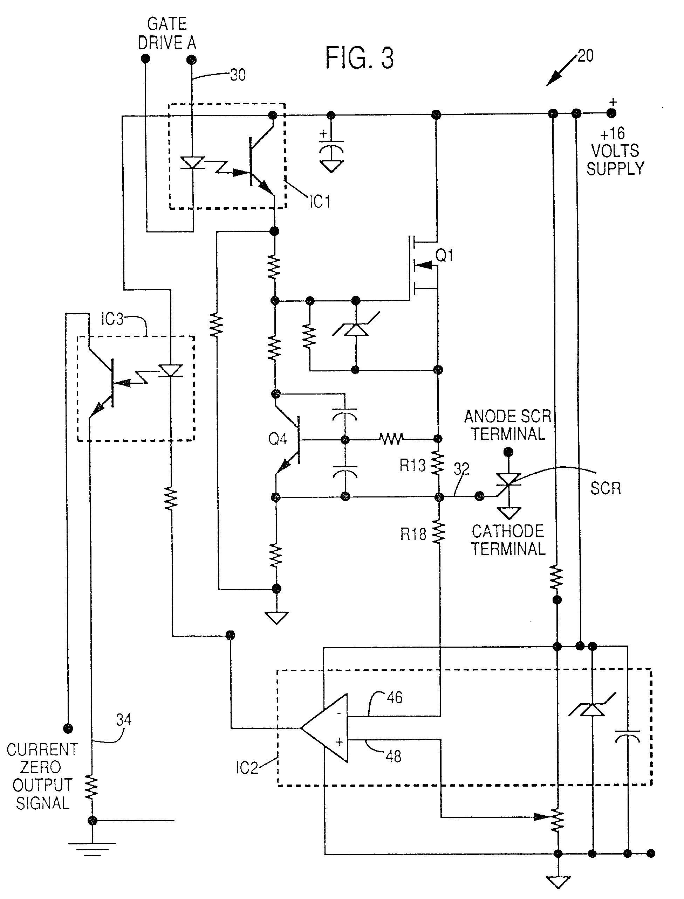

The schematic in Fig. 3 shows one method of achieving gate threshold detection of an SCR using a comparator and voltage reference. This circuit has been tested and was used to create the current voltage plot provided. The schematic shown has a negative input 46 of a comparator IC2 connected to the gate 32 of an SCR 24 through a resistor 18. The resistor was added for short circuit protection and is not required otherwise. The positive input 48 of IC2 is fed an adjustable threshold level, in this example set at 0.1 volts DC.

The SCR driver and detection 20 operates by turning on SCR1 through transistor Q1. Q1 is controlled by an opto isolator IC1. Whenever the gate drive signal A is turned on through the isolator, the photo current turns on transistor IC1 providing current to the gate of the transistor Q1. This current is supplied from a 16 volt power source which turns the transistor on. The current then feeds through resistor R13 into the gate of the SCR1. R13 is a very small resistor on the order of a few ohms and is merely used to provide enough sensing capability to enable the current control transistor Q4 to monitor and control the amount of drive supplied to Q1. This arrangement provides the current going to the gate of the SCR to be some value set by R13's threshold and controlled by Q4. This enables turning on a device from the 16 volt power source supplying gate current. At some time, it may be desirable to turn off the SCR1, whereupon the gate drive A to the photo diode is disconnected from the source of power. IC1 turns off, removing the drive to Q1, causing the gate current feeding the SCR1 to be turned off. SCR1, however, may not turn off immediately, because it may be at mid-cycle point through a sine wave power conduction curve. This mid-cycle event would mean that the SCR1 would turn off, depending on the power line frequency, some number of milliseconds later. The time in which the SCR1 turns off can often be crucial in interconnecting several devices together. In this particular application, resistor R18 having several thousand ohms resistance, monitors the voltage at the gate of the SCR1. This voltage is compared to a reference voltage which on IC2 is provided a 100 millivolt threshold which is used as the reference. The comparator IC2 will monitor the gate voltage of the SCR and at the point in which the SCR's gate voltage diminishes below 100 millivolts, the output of IC2 will go logically low, and draw current from the 16 volt power supply through IC3's LED photo diode. This LED then provides output current through the opto-isolator to turn on IC3, the output transistor. This provides an optically isolated interface to determine at which time the SCR1 is turned off. The method by which this is all monitored makes use of the fact that when the SCR's gate current is removed, the SCR continues to be in conduction until such time as its polarity anode to cathode is reversed. This might take several milliseconds to occur, depending on the power line frequency. In the present embodiment there is actual monitoring of the gate voltage which is internally supplied by the SCR in a regenerative effect. This regeneration is going to occur as long as there is proper amplitude and polarity across the SCR under load. By monitoring this gate voltage to see when it falls below 100 millivolts, we have been able to reliably monitor the condition of the SCR to determine when it falls out of condition and turns off within some 30 microseconds. This is several orders of magnitude more precise in time than can be done with standard current probes.

When the SCR is not conducting current and the external gate drive is not present, the comparator will indicate this status by outputting a high output logic level. This signal corresponds to that point at which the SCR is capable of blocking current and may be considered off. The speed and precision of this detection method in addition to its low cost provide an attractive method to monitor condition in SCR devices. The signal at the SCR gate is a small DC level that has none of the disturbances present in the load current. This reduced noise detection approach replaces the need to monitor the load with zero current sensing devices.

In SCR circuits that utilize multiple SCRs, this gate detection approach can improve the systems control by better describing each SCR's turn-off point. As stated previously, this gate monitoring of the SCR gate lead will indicate internal biasing and is essentially "load noise free." This cathode referenced signal affords a common drive and detection sense point for the operation of SCR devices.

The need to allow sufficient turn-off delay time within the SCR is illustrated in Fig. 1. The anode power supply lead is interrupted several times by a loose connection causing erratic currents. The SCR does not turn off and the upper gate voltage trace indicates ringing that is decaying in amplitude. After the connection is restored, the current returns to its normal value proving that the SCR has not extinguished conduction during the time period of about 10 microseconds that power is removed.

Figs. 2A and 2B show the decay of the internally regenerated gate voltage signal resulting from the passage of current through the SCR structure. The lower trace in each photo shows removal of the six amp DC load current and the intermediate parasitic ringing on the gate voltage decay curve. Fig. 2A shows the decay time to reach 0.0 volts requires approximately 60 microseconds; however, the 100 millivolt point takes only about 30 microseconds as shown in Fig. 2B. 100 millivolts appears to be the threshold below which the SCR is sufficiently turned off to inhibit spontaneous turn-on. These room temperature measurements are consistent over a sample of several different power level SCRs.

Lab testing of the gate detector circuits has discovered some interesting and previously unrecorded SCR gate responses. Operation of the SCR with very low voltage direct current sources has demonstrated that the internal SCR regenerative currents develop a voltage at the gate terminal indicating the state of conduction within the device.

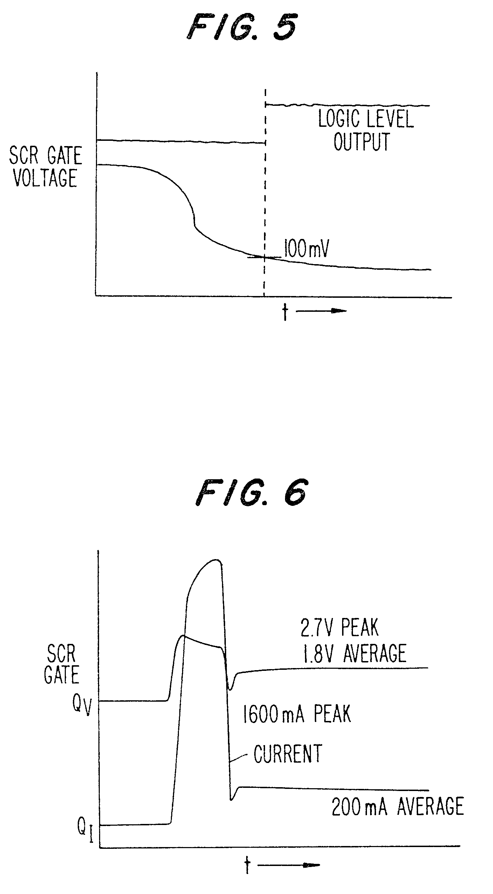

Fig. 4 shows in the upper trace, the gate detector circuit output that indicates a high logic level when the SCR gate to cathode voltage decays below a preset threshold of 100 millivolts. The lower trace shows the interruption of current passing through the SCR as the anode lead is removed.

The elapsed time of about 30 microseconds from that point at which the SCR current falls to zero and the detector switches to a high state is due to the time required for the internal SCR gate charge to decay below the 100 millivolt threshold.

During these tests, the SCR was turned on by a 15 microsecond wide 1.5 amp current pulse fed to the gate terminal. The anode voltage source was adjusted to allow several amperes of current and after turn-on, the gate drive was removed. The anode current was adjusted to determine how the gate decay timing was affected by anode current. Very low anode currents allow shorter decay times as there is less drive internally to start with, but the decay time only varies from 20 to 30 microseconds as the SCR current was changed from 0.1 amps to 6.0 amps.

This gate voltage decay provides a reliable indicator to show when the SCR actually loses sufficient amplitudes of the internal regenerative drive to sustain conduction. Monitoring a specific gate voltage point on a given device accurately defines the point at which that specific SCR can be considered to be non-conductive. This point tracks well with the internal die temperature of the device. Timing errors are removed in this method and it is not necessary to monitor a line current sensor for the passage of the circuit current through a zero value. An SCR zero line current can occur while the SCR is still internally forward-biased and thus able to restart conduction without additional external gate triggering.

There is an internal loss of gain within the SCR gate region at the point in time the SCR loses its ability to sustain conduction. To gather characteristic data in this area of operation, a 3000 PIV SCR rated at 500 amperes was connected to a series resistive load and variable DC power source.

The source voltage was adjusted to approximately 2 volts and the gate voltage was observed with respect to the cathode terminal. The SCR was placed into conduction with a brief pulse of gate current and then the gate source was disconnected. The power source was adjusted to decrease the voltage available at the SCR until the SCR ceased to conduct current.

Fig. 5 shows in its upper trace a high logic level until the gate voltage detector indicates that the residual SCR gate voltage has decayed below the 100 millivolt threshold. The lower trace shows the internally regenerated gate voltage at the point the SCR anode to cathode current becomes insufficient to maintain full conduction. The earlier portion of this curve rolls off as the SCR current is reduced causing the gain to diminish below the critical regeneration point of 0.1 volts.

At lower device currents, the curve changes pitch and becomes an exponential decay curve as the stored charge on the gate to cathode region dissipates. This area of the SCR turn-off curve is due to leakage and recombination currents through the device as the residual gate bias ceases to be able to maintain sufficient conduction.

This lower waveform shows the change in operating points within an SCR as its load current falls below the minimum holding current limit of the device. This data allows better understanding of the operation of the SCR and demonstrates the need to allow ample turn-off time for the SCR device. If the proper polarity voltage is applied to the SCR at this point, the SCR could easily support enough current to regenerate its own drive voltage and "restart" full conduction without the addition of any gate drive. This potential for undesired turn-on must be anticipated so that it can be guarded against in proper circuit designs.

The gate drive circuit as shown, sources gate currents in the 1.5 amp range for a duration of 10-20 microseconds into the SCR gate. Sustained gate current is set at 250 milliamperes after the initial pulse waveform. Fig. 6 indicates the gate to cathode voltage signal applied during a turn-on pulse of the SCR and the resulting gate current waveform.

The SCR regeneration detector circuit has been evaluated at variable thresholds from 80 to 500 millivolts. Nominal test results obtained at the gate to cathode voltage detection level indicate a desirable threshold level to be 100 millivolts. Timing between the removal of the anode current and the decay of the regenerative gate signals runs about 30 microseconds. This time period represents the SCR turn-off delay required for the gate signal to diminish below its regeneration threshold value, after the anode current falls to zero.

Although a specific embodiment has been disclosed, it will be understood by those having skill in the art that changes can be made to that specific embodiment without departing from the spirit and the scope of the invention.

**Claims**

1. A method of measuring the electrical conduction of a silicon controlled rectifier within a drive circuit, the SCR having an anode, gate and cathode comprising the steps of:

   sensing the absence of a drive signal applied to the SCR;

   measuring the amplitude of the voltage at the gate terminal with reference to the cathode during the absence of the drive signal;

   comparing the gate to cathode voltage to a predetermined voltage level indicative of when the SCR is in an off state; and

   outputting a signal when the gate voltage is below the predetermined level as a representation that the SCR is completely turned off and capable of blocking an applied potential.

2. The method of claim 1 wherein the comparing is made to a voltage in the range of 80-500 millivolts.

3. The method of claim 2 wherein the comparing is made to a 100 millivolt level.

4. An apparatus for determining the conductive state of a semiconductor controlled rectifier SCR within a drive circuit, the SCR having an anode, gate and cathode comprising:

   sensing means (IC1, Q1, Q4) for determining the absence or presence of a drive signal (A) to the gate of the SCR;

   measuring means (R 18) for monitoring the gate to cathode voltage of the SCR during the absence of the drive signal;

   comparator means (IC2) for comparing the monitored voltage at the gate of the SCR to a predetermined reference voltage level indicative of when the SCR is in an off state; and

   outputting means (IC3) for generating an electrical signal when the monitored voltage is below the predetermined voltage level to indicate when the SCR's gate to cathode PN junction potential has decayed below the point where it is capable of regenerating a sufficient gate signal to reconduct through the anode to cathode current path.

5. The apparatus of claim 4 wherein the predetermined reference voltage is in the range of 50-800 millivolts.

6. The apparatus of claim 5 wherein the predetermined reference voltage level is above 100 millivolts.

7. The apparatus of anyone of the claims 4 to 6 wherein a nominal drive current is applied to the gate of the SCR to maintain sufficient potential to ensure regeneration within the gate to cathode junction.

# FIG. 1

GATE VOLTAGE

200 mV

$Q_V$

SCR NEVER TURNS OFF

ANODE CURRENT

6A

$Q_I$

$t \longrightarrow$

# FIG. 4

VOLTAGE

30mS

SCR GATE

CURRENT

$t \longrightarrow$

## FIG. 2a

200mV

$Q_V$

6A

$Q_I$

LOAD OFF

100 mV THRESHOLD

GATE VOLTAGE

GATE CURRENT

$t \longrightarrow$

60 mS

## FIG. 2b

$Q_V$

6A

$Q_I$

LOAD OFF

GATE VOLTAGE

100mV

GATE CURRENT

$t \longrightarrow$

30mS

EP 0 472 902 A2

FIG. 3

GATE DRIVE A

+16 VOLTS SUPPLY

IC1
IC3
Q1
Q4
R13
R18
ANODE SCR TERMINAL
CATHODE TERMINAL
SCR
CURRENT ZERO OUTPUT SIGNAL
IC2

8

## FIG. 5

SCR GATE
VOLTAGE

LOGIC LEVEL
OUTPUT

100mV

t ⟶

## FIG. 6

SCR
GATE

$Q_V$

$Q_I$

2.7V PEAK
1.8V AVERAGE

1600 mA PEAK

CURRENT

200 mA AVERAGE

t ⟶